# EUROPÄISCHE PATENTSCHRIFT

(11) **EP 3 378 104 B1**
(45) Veröffentlichungstag und Bekanntmachung des Hinweises auf die Patenterteilung: **10.06.2020**
(21) Anmeldenummer: 16797573.9
(22) Anmeldetag: 17.11.2016
(51) Int. Cl.: H01L 31/078

(54) **SOLARZELLE MIT MEHREREN DURCH LADUNGSTRÄGER-SELEKTIVE KONTAKTE MITEINANDER VERBUNDENEN ABSORBERN**
SOLAR CELL HAVING A PLURALITY OF ABSORBERS CONNECTED TO ONE ANOTHER BY MEANS OF CHARGE-CARRIER-SELECTIVE CONTACTS
CELLULE SOLAIRE COMPRENANT PLUSIEURS ABSORBEURS RELIÉS ENTRE EUX PAR DES CONTACTS SÉLECTIFS PORTEURS DE CHARGE

(30) Priorität: 19.11.2015 DE 102015015017
(43) Veröffentlichungstag der Anmeldung: 26.09.2018
(73) Patentinhaber: Institut für Solarenergieforschung GmbH, 31860 Emmerthal (DE)
(72) Erfinder: PEIBST, Robby, 31832 Springe (DE)
(74) Vertreter: Qip Patentanwälte Dr. Kuehn & Partner mbB
(86) Internationale Anmeldenummer: PCT/EP2016/078005
(87) Internationale Veröffentlichungsnummer: WO 2017/085186

(56) Entgegenhaltungen:
- US-A- 4 496 788
- STEVE ALBRECHT ET AL: "Monolithic perovskite/silicon-heterojunction tandem solar cells processed at low temperature", ENERGY & ENVIRONMENTAL SCIENCE, Bd. 9, Nr. 1, 27. Oktober 2015 (2015-10-27), Seiten 81-88, XP055341828, UK ISSN: 1754-5692, DOI: 10.1039/C5EE02965A
- YOUNGSEOK LEE ET AL: "Ultrathin Oxide Passivation Layer by Rapid Thermal Oxidation for the Silicon Heterojunction Solar Cell Applications", INTERNATIONAL JOURNAL OF PHOTOENERGY, Bd. 2012, 1. Januar 2012 (2012-01-01), Seiten 1-5, XP055342085, US ISSN: 1110-662X, DOI: 10.1155/2012/753456
- GREEN M.A: "SILICON WAFER-BASED TANDEM CELLS: THE ULTIMATE PHOTOVOLTAIC SOLUTION?", PROCEEDINGS / EU PVSEC 2013, 28TH EUROPEAN PHOTOVOLTAIC SOLAR ENERGY CONFERENCE AND EXHIBITION, 16. Dezember 2013 (2013-12-16), Seiten 7-10, XP040634740, ISBN: 978-3-936338-33-1
- SYMKO-DAVIES M.: "PROGRESS IN HIGH-PERFORMANCE PV: POLYCRYSTALLINE THIN-FILM TANDEM CELLS", NINETEENTH EUROPEAN PHOTOVOLTAIC SOLAR ENERGY CONFERENCE: PROCEEDINGS OF THE INTERNATIONAL CONFERENCE HELD IN PARIS, FRANCE, 7 - 11 JUNE 2004, 7. Juni 2004 (2004-06-07), Seiten 1651-1656, XP040510788, ISBN: 978-3-936338-15-7
- SIVANANTHAN S.: "MULTIJUNCTION SINGLE-CRYSTAL CdTe-BASED SOLAR CELLS: OPPOTUNITIES AND CHALLENGES", PROCEEDINGS OF SPIE, 1. Januar 2010 (2010-01-01), Seiten 1-14, XP040536867,
- GUY BEAUCARNE: "Silicon Thin-Film Solar Cells", ADVANCES IN OPTOELECTRONICS, Bd. 2007, 1. Januar 2007 (2007-01-01), Seiten 1-12, XP055148385, DOI: 10.1155/2007/36970
- FELDMANN FRANK ET AL: "Efficient carrier-selective p- and n-contacts for Si solar cells", SOLAR ENERGY MATERIALS AND SOLAR CELLS, ELSEVIER SCIENCE PUBLISHERS, AMSTERDAM, NL, Bd. 131, 30. Juni 2014 (2014-06-30), Seiten 100-104, XP029075017, ISSN: 0927-0248, DOI: 10.1016/J.SOLMAT.2014.05.039

## Beschreibung

### GEBIET DER ERFINDUNG

Die vorliegende Erfindung betrifft eine Solarzelle, insbesondere eine Tandem-Solarzelle mit mehreren Absorbern.

### TECHNISCHER HINTERGRUND

Solarzellen dienen zur Umwandlung der Energie des Sonnenlichtes in elektrische Energie unter Ausnutzung des photoelektrischen Effektes. Je nach Absorber-Material kann jedoch nur ein bestimmter Teil des Sonnenspektrums effizient genutzt werden. Besteht der Absorber beispielsweise aus einem Halbleitermaterial, können Photonen mit Energien unterhalb der Bandlücke nicht direkt zur Generation von Elektronen-Loch-Paaren beitragen und werden daher kaum absorbiert. Photonen mit Energien weit oberhalb der Bandlücke generieren zwar Elektronen-Loch-Paare, jedoch thermalisieren Elektronen und Löcher aus den angeregten höherenergetischen Zuständen in niederenergetische Zustände nahe den Bandkanten und geben dabei die Energiedifferenz in Form von Wärme ab.

Eine Möglichkeit, diese beiden Verlustmechanismen im Bereich hoch- und niederenergetischer Photonen zu minimieren ist, zwei oder mehr Absorber aus unterschiedlichen Materialien, die jeweils Strahlungsenergie aus unterschiedlichen Bereichen des Sonnenspektrums effizient in elektrische Energie umwandeln, zu verwenden. Dabei liegen auf einer der Sonneneinstrahlung zugewandten Seite der Solarzelle vorzugsweise der oder die Absorber, die effizient hochenergetische Photonen für die photovoltaische Energieumwandlung nutzen und die Photonen mit geringeren Energien effizient zu den darunterliegenden Absorber(n) transmittieren.

Diese Solarzellenstruktur, die als Tandem-Solarzelle oder Multijunction-Zelle bezeichnet wird, ist seit langem bekannt, beispielsweise aus der US 4,496,788, und im Bereich von höchsteffizienten Weltraumsolarzellen oder im Bereich von terrestrischen Solarzellen, bei denen das Sonnenlicht über Optiken auf eine kleine Fläche konzentriert wird, bereits kommerzialisiert.

STEVE ALBRECHT ET AL: "Monolithic perovskite/silicon-heterojunction tandem solar cells processed at low temperature", ENERGY & ENVIRONMENTAL SCIENCE, Bd. 9, Nr. 1, 27. Oktober 2015, Seiten 81-88, offenbart eine Tandem-Solarzelle.

Erstrebenswert wäre es, Tandem-Solarzellen auch für terrestrische, nicht-konzentrierende photovoltaische Anwendungen nutzen zu können. Hierzu müssen die hohen Herstellungs- und Materialkosten herkömmlicher Tandem-Solarzellen jedoch deutlich gesenkt werden. Dazu bietet es sich an, Tandem-Solarzellen auf relativ kostengünstigen und relativ effizienten (mono- oder multi-) kristallinen Silizium-Solarzellen aufzubauen, d.h., auf dem Silizium-Absorber einen oder mehrere Absorber aus von kristallinem Silizium verschiedenen Materialien aufzubringen. Möglich wären Materialen, die eine photovoltaische Energieumwandlung für Photonenenergien unterhalb von der Silizium-Bandlücke von 1,12 eV erlauben, wobei ein solcher Absorber auf der der Sonneneinstrahlung abgewandten Seite des Siliziumabsorbers aufgebracht werden würde. Alternativ könnten Absorber aus Materialien, die Photonen mit Energien unterhalb von 1,4 eV effizient transmittieren und höherenergetische Photonen effizient für die photovoltaische Energieumwandlung nutzen, auf der der Sonneneinstrahlung zugewandten Seite des Silizium-Absorbers aufgebracht werden. Silizium-Solarzellen mit nur einem pn-Übergang werden ihrerseits ständig weiterentwickelt. Eine wesentliche Verbesserung der Energieumwandlungseffizienz kann hierbei durch eine Verbesserung der Qualität der Oberflächenpassivierung erreicht werden. Dielektrische Passivierschichten, wie beispielsweise Siliziumoxide (SiOx), Siliziumnitride (SiNx) oder Aluminiumoxide (Al2O3), isolieren die jeweils bedeckten Bereiche elektrisch, so dass zur Extraktion von Ladungsträgern zusätzliche nichtpassivierte Kontakte nötig sind. Typischerweise grenzt hierbei ein Metall lokal direkt an das kristalline Silizium, wodurch eine defektreiche und somit stark rekombinationsaktive Grenzfläche gebildet wird. Im Gegensatz dazu bieten sogenannte Ladungsträger-selektive Kontakte die Möglichkeit, die damit bedeckten Oberflächen nicht nur exzellent zu passivieren, sondern in diesen Bereichen auch einen Ladungsträgertyp, d.h. entweder Elektronen oder Löcher, selektiv aus dem Siliziumabsorber zu extrahieren.

Der Begriff "Ladungsträger-selektiver Kontakt" umfasst unterschiedliche Ausführungsformen. Am bekanntesten hierfür sind im Bereich der Silizium-Photovoltaik Heteroübergänge zwischen amorphem, wasserstoffreichem Silizium und dem kristallinen Silizium-Absorber. Die elektrischen Eigenschaften dieser Heteroübergänge degradieren jedoch oft stark bei Temperaturen oberhalb von 200°C. Eine aus der Bipolar-Elektronik bekannte Alternative, die in den letzten Jahren verstärkt auch in der Photovoltaik untersucht wurde, sind Ladungsträger-selektive Kontakte bestehend aus einem dünnen Grenzflächenoxid (oder allgemeiner aus einem Grenzflächendielektrikum) und einer darauf abgeschiedenen Schicht aus dotiertem amorphem oder teilkristallinem oder polykristallinem Silizium. Das Grenzflächenoxid wird teilweise auch als Tunneloxid bezeichnet, wobei der dominierende physikalische Stromtransportmechanismus durch das Oxid hindurch noch Gegenstand aktueller wissenschaftlicher Debatten ist. Je nachdem, ob die amorphe oder teilkristalline oder polykristalline Silizium-Schicht auf dem Grenzflächenoxid n oder p dotiert ist, ist der Ladungsträger-selektive Kontakt entweder transparent bzw. durchlässig für Elektronen oder Löcher und blockiert den jeweils anderen Ladungsträgertyp nahe der Grenzfläche zwischen dem Oxid und dem Silizium-Absorber. Ladungsträger-selektive Kontakte bestehend aus einem dünnen Grenzflächenoxid und einer darauf abgeschiedenen Schicht aus dotiertem amorphem oder teilkristallinem oder polykristallinem Silizium sind meist stabil bei Prozesstemperaturen bis mindestens 1050°C. Ihre exzellente Passivierqualität ist typischerweise unabhängig von der Art der sich darauf befindenden Schichten.

### ZUSAMMENFASSUNG DER ERFINDUNG UND VON AUSFÜHRUNGSFORMEN

Es kann ein Bedürfnis an einer Tandem-Solarzelle bestehen, die einen hohen Wirkungsgrad aufweist und/oder einfach und kostengünstig hergestellt werden kann.

Es kann insbesondere ein Bedürfnis bestehen, eine Tandem-Solarzelle mit kristallinem Silizium als Material für einen Absorber so auszuführen, dass die zu dem anderen Absorber hin gerichtete Oberfläche des Silizium-Absorbers sehr gut passiviert ist, so dass unabhängig von den Eigenschaften der an diese Passivierung angrenzenden Schichten eine Rekombination von im Silizium-Absorber generierten Elektronen und Löchern an dieser Oberfläche des Silizium-Absorbers minimiert wird.

Es kann ein Bedürfnis bestehen, eine Tandem-Solarzelle mit kristallinem Silizium als Material für einen Absorber so auszuführen, dass an der zu dem anderen Absorber hin gerichteten Oberfläche des Silizium-Absorbers ein Ladungsträgertyp sehr effizient extrahiert werden kann, so dass die hauptsächlich aus dem Silizium-Absorber bestehende Sub-Zelle elektrisch gut mit der angrenzenden Sub-Zelle verbunden ist.

Es kann außerdem ein Bedürfnis bestehen, zwischen der hauptsächlich aus dem kristallinen Silizium-Absorber bestehende Sub-Zelle und der hauptsächlich aus einem anderen Absorber-Material bestehenden Sub-Zelle einen Tunnelkontakt auszubilden.

Es kann außerdem ein Bedürfnis bestehen, eine Tandem-Solarzelle mit kristallinem Silizium als Material für einen Absorber so auszuführen, dass sich zusätzliche Möglichkeiten zur Feinanpassung der in den Sub-Zellen generierten Stromdichten ergeben.

Es kann außerdem ein Bedürfnis bestehen, bei der Herstellung einer Tandem-Solarzelle mit kristallinem Silizium als Material für einen Absorber einen Herstellungsprozess zu verwenden, bei dem bestimmte Schritte Prozesstemperaturen oberhalb von 200 °C implizieren.

Die erstgenannten Bedürfnisse können mit dem Gegenstand des unabhängigen Anspruchs der vorliegenden Anmeldung erfüllt werden. Die außerdem genannten Bedürfnisse können mit dem Gegenstand zumindest eines der abhängigen Ansprüche der vorliegenden Anmeldung erfüllt werden.

Gemäß einem Aspekt der vorliegenden Erfindung wird eine Tandem-Solarzellenstruktur beschrieben, die mindestens zwei Absorber zur Umwandlung von Strahlungsenergie in elektrische Energie aufweist, wobei ein erster Absorber aus kristallinem Silizium besteht. Für den oder die anderen (zweiten) Absorber kommt eine Vielzahl von Materialien in Frage, die jeweils andere Spektralbereiche des Sonnenspektrums effizient für die photovoltaische Energieumwandlung nutzen. Die Tandem-Solarzelle ist monolithisch aufgebaut, d.h., die einzelnen Sub-Zellen sind in Serie verschaltet und ihre Absorber vorzugsweise weitgehend parallel zueinander übereinander gestapelt. Die dem angrenzenden Absorber aus einem von kristallinem Silizium verschiedenen Material zugewandte Seite des kristallinen Silizium-Absorbers weist einen Ladungsträger-selektiven Kontakt auf. Sollte der kristalline Silizium-Absorber zwischen zwei Absorbern aus anderen Materialien eingebettet sein, weisen beide Seiten des Silizium-Absorbers Ladungsträger-selektive Kontakte auf. Die Ladungsträger-selektiven Kontakte bestehen gemäß der vorliegenden Erfindung aus einem dünnen Grenzflächendielektrikum (z.B. einem Grenzflächenoxid), beispielsweise einer nur wenige Nanometer dünnen Schicht aus Siliziumdioxid, und einer darauf abgeschiedenen amorphen oder teilkristallinen oder polykristallinen, überwiegend (d.h. zu mehr als 50%) aus Silizium bestehenden Schicht. Letztere kann beispielsweise n dotiert sein, wodurch der Ladungsträger-selektive Kontakt die im Silizium-Absorber generierten Elektronen effizient zu den angrenzenden Schichten weiterleiten und die im Silizium-Absorber generierten Löcher nahe der Grenzfläche zwischen dem Silizium-Absorber und dem Grenzflächenoxid blockieren würde. Alternativ kann die amorphe oder teilkristalline oder polykristalline, überwiegend aus Silizium bestehende Schicht p dotiert sein, wodurch der Ladungsträger-selektive Kontakt die im Silizium-Absorber generierten Löcher effizient zu den angrenzenden Schichten weiterleiten und die im Silizium-Absorber generierten Elektronen nahe der Grenzfläche zwischen dem Silizium-Absorber und dem Grenzflächenoxid blockieren würde.

Bei ausreichend hoher Dotierung der amorphen oder teilkristallinen oder polykristallinen, überwiegend aus Silizium bestehenden Schicht kann sich zwischen dieser und der angrenzenden Schicht ein Tunnelkontakt ausbilden.

Ohne die Erfindung einzuschränken, können Aspekte und Ausführungsformen unter anderem als auf den nachfolgend beschriebenen Erkenntnissen und Ideen beruhend angesehen werden.

Wie einleitend angemerkt, wurde erkannt, dass für terrestrische nicht- bzw. niedrig-konzentrierende Anwendungen bevorzugt kostengünstige Tandem-Solarzellenkonzepte in Frage kommen, beispielsweise monolithisch aufgebaut auf einem relativ kostengünstigen Silizium-Substrat wie z.B. einem Siliziumwafer. Es wird als vorteilhaft angesehen, das Silizium-Substrat nicht nur als mechanischen Träger, sondern auch als einen von mindestens zwei aktiven Absorbern in der Tandem-Solarzellenstruktur zu verwenden. Es ist davon auszugehen, dass die Grenzfläche zwischen dem kristallinen Silizium und der daran angrenzenden Schicht, die zur benachbarten Sub-Zelle aus einem anderen Material gehört, eine hohe Dichte an Grenzflächenzuständen aufweist. Beispielsweise könnte letztere Schicht, falls ebenfalls kristallin, eine andere Gitterkonstante aufweisen als Silizium. Auch wenn die an das kristalline Silizium angrenzende, zur benachbarten Sub-Zelle aus einem anderen Material gehörende Schicht eine amorphe Mikrostruktur aufweist, ist eine hohe Dichte an Defektzuständen an der Grenzfläche zwischen dieser Schicht und dem kristallinen Silizium wahrscheinlich.

An diesen Grenzflächenzuständen können die im Silizium-Absorber generierten Ladungsträgerpaare aus Elektronen und Löchern rekombinieren, wodurch die Zellleistung deutlich verringert würde.

Es wurde nun erkannt, dass es vorteilhaft wäre, die Grenzfläche zwischen dem kristallinen Silizium und der daran angrenzenden Schicht, die zur benachbarten Sub-Zelle aus einem anderen Material gehört, zu passivieren, d.h. die Grenzflächenzustandsdichte und damit die Rekombinationsverluste zu minimieren. Auf dem kristallinen Silizium abgeschiedene dielektrische Schichten, die üblicherweise in Solarzellen mit nur einem Absorber aus kristallinem Silizium zur Passivierung verwendet werden, sind für die Solarzellenstruktur gemäß der vorliegenden Erfindung unvorteilhaft. Bei ganzflächiger Abscheidung würden solche dielektrischen Schichten die Silizium-Subzelle von der benachbarten Sub-Zelle elektrisch isolieren, wodurch die erforderliche gut leitfähige Verbindung aller Sub-Zellen nicht gewährleistet wäre. Die bei Solarzellen mit nur einem Absorber aus kristallinen Silizium üblicherweise angewandte lokale Öffnung der dielektrischen Isolationsschicht würde einen lateralen Stromfluss innerhalb der Sub-Zellen implizieren. Die dafür notwendige Querleitfähigkeit in allen Sub-Zellen für beide Ladungsträgerarten - Elektronen und Löcher - ist bei der Solarzellenstruktur gemäß der vorliegenden Erfindung in der Regel nicht gegeben, zumindest nicht in den typischerweise sehr dünnen Sub-Zellen aus einem von Silizium verschiedenen Material.

Ein Ladungsträger-selektiver Kontakt bestehend aus beispielsweise einem dünnen Grenzflächenoxid und einer darauf abgeschiedenen dotierten, amorphen oder teilkristallinen oder polykristallinen, überwiegend aus Silizium bestehenden Schicht, der sich auf der zur benachbarten Sub-Zelle gerichteten Oberfläche des Silizium-Absorbers befindet, bietet hier entscheidende Vorteile: Einerseits stellt er eine exzellente Passivierung der Oberfläche des Silizium-Absorbers sicher und minimiert somit an dieser Stelle auftretende Rekombinationsverluste. Andererseits leitet ein solcher Ladungsträger-selektiver Kontakt auch über die gesamte Fläche einen Ladungsträgertyp, d.h. Elektronen im Falle einer n dotierten und Löcher im Falle einer p dotierten amorphen oder teilkristallinen oder polykristallinen Silizium-Schicht auf dem Grenzflächenoxid, an die angrenzende Sub-Zelle weiter. Somit findet der Stromfluss vorzugsweise rein vertikal statt, und eine laterale Querleitfähigkeit in jeder Sub-Zelle für beide Ladungsträgertypen ist nicht notwendig.

Es wurde außerdem erkannt, dass im Falle eines monolithischen Aufbaus einer Tandemsolarzelle eine gut leitfähige elektrische Verbindung der Sub-Zellen durch Tunnelkontakte vorteilhaft ist. Hierfür sind hohe Dotierungen in den aneinandergrenzenden, den Tunnelkontakt bildenden Schichten vorteilhaft, da hohe Dotierung geringe Raumladungszonenbreiten und somit hohe Tunnelwahrscheinlichkeiten implizieren. Um diese Forderung auf der Seite der Silizium-Subzelle zu erfüllen, könnte der Silizium-Absorber an seiner Oberfläche hoch dotiert werden. Eine direkt in das kristalline Silizium eingebrachte hohe Dotierung impliziert jedoch auch signifikante Rekombinationsverluste, da die Minoritäts-Ladungsträger-Lebensdauer im hochdotierten Bereich aufgrund von Auger-Rekombination sehr gering ist.

Auch hierfür bietet ein vorzugsweise direkt auf die Oberfläche des Silizium-Absorbers aufgebrachter Ladungsträger-selektiver Kontakt bestehend aus beispielsweise einem dünnen Grenzflächenoxid und einer darauf abgeschiedenen dotierten, amorphen oder teilkristallinen oder polykristallinen Silizium-Schicht deutliche Vorteile: Da die Minoritäts-Ladungsträger bereits an der Grenzfläche zwischen dem Silizium-Absorber und dem Grenzflächenoxid geblockt werden, erreichen sie die darauf abgeschiedene amorphe oder teilkristalline oder polykristalline Silizium-Schicht gar nicht. DieMinoritäts-Ladungsträger-Lebensdauer in letztgenannter Schicht ist somit irrelevant. Daher kann die Dotierung der amorphen oder teilkristallinen oder polykristallinen Silizium-Schicht ausreichend hoch (d.h. beispielsweise höher als 10¹⁸, vorzugsweise höher als 10¹⁹ und weiter bevorzugt höher als 10²⁰ cm⁻³) gewählt werden, um einen leitfähigen Tunnelkontakt zur angrenzenden Sub-Zelle sicher zu stellen, ohne dass dadurch Verluste durch Auger-Rekombination in dieser Schicht impliziert würden.

Es wurde außerdem erkannt, dass bei einer monolithisch aufgebauten Tandem-Solarzelle, die einer Serienschaltung aller Sub-Zellen entspricht, die Stromstärke durch alle Subzellen gleich groß sein muss. Dies setzt ein Design der einzelnen Subzellen dergestalt voraus, dass der Generationsstrom in jeder Sub-Zelle gleich groß ist. Sollte dies nicht der Fall sein, fließen innerhalb der Tandemzelle unerwünschte Ausgleichsströme, die die Zellleistung unter Umständen signifikant beeinträchtigen. Eine exakte Anpassung des Generationsstromes in allen Sub-Zellen ist anspruchsvoll. Möglicherweise setzten hierbei weitere Randbedingungen Grenzen, beispielsweise eine begrenzte maximale Dicke von Sub-Zellen aus einem von kristallinem Silizium verschiedenen Material.

Gemäß einer Ausführungsform der vorliegenden Erfindung könnte es vorteilhaft sein, die Dicke und / oder die Dotierung der amorphen oder teilkristallinen oder polykristallinen Silizium-Schicht als zusätzlichen Freiheitsgrad zur Feinanpassung der Generationsströme zu verwenden. Je nach Dicke und Dotierung können konstruktive oder destruktive Interferenzen genutzt werden, um einen Teil der einfallenden Strahlung entweder zurück in die Sub-Zelle aus einem von kristallinen Silizium verschiedenen Material zu reflektieren oder gezielt in die Silizium-Subzelle zu transmittieren. Je nach Dotierung und Dicke findet in der amorphen oder teilkristallinen oder polykristallinen Silizium-Schicht Absorption statt, beispielsweise verbunden mit der Anregung freier Ladungsträger in höherenergetische Zustände. Dieses Licht steht dann nicht mehr zur Generation von Elektron-Loch-Paaren im Silizium-Absorber zur Verfügung, so dass der Generationsstrom in der Silizium-Subzelle abgesenkt wird. Diese Absenkung entspricht einem optischen Verlust. Dennoch kann es unter Umständen für die Gesamtleistung der Zelle vorteilhaft sein, diesen optischen Verlust in Kauf zu nehmen, um elektrische Verluste durch eine Abweichung der Generationsströme in den einzelnen Subzellen zu minimieren.

Es wurde außerdem erkannt, dass sich die oben genannten Vorteile unter Umständen auch mit anderen Ladungsträger-selektiven Kontakten, d.h. mit Alternativen zu der Doppelschicht bestehend aus einem dünnen Grenzflächenoxid und einer darauf abgeschiedenen dotierten, amorphen oder teilkristallinen oder polykristallinen, überwiegend aus Silizium bestehenden Schicht, erzielen lassen.

Beispielsweise weisen Hetero-Übergänge zwischen dem kristallinen Silizium-Absorber und einer darauf abgeschiedenen wasserstoffhaltigen amorphen Silizium-Schicht ähnliche Eigenschaften auf, insbesondere in Bezug auf eine exzellente Oberflächenpassivierung.

Dennoch bieten Ladungsträger-selektive Kontakte bestehend aus einer aus einem dünnen Grenzflächenoxid und einer darauf abgeschiedenen dotierten, amorphen oder teilkristallinen oder polykristallinen, überwiegend aus Silizium bestehenden Schicht einen wichtigen Vorteil hinsichtlich der Integration in einen Zell-Herstellungsprozess: Die elektrischen Eigenschaften dieser Ladungsträger-selektive Kontakte sind sehr temperaturstabil und erlauben daher die Anwendung von nachfolgenden Prozessschritten mit Prozesstemperaturen von bis zu 1000 °C und darüber. Im Gegensatz dazu degradieren beispielsweise Hetero-Übergänge zwischen dem kristallinen Silizium-Absorber und darauf abgeschiedenen wasserstoffhaltigen amorphen Silizium-Schichten bereits bei Temperaturen über 200 °C, was eine starke Einschränkung bezüglich möglicher Herstellungsprozesse für die Tandem-Solarzelle impliziert.

Es wurde außerdem erkannt, dass die Tandem-Solarzellenstruktur gemäß der vorliegenden Erfindung eine große Flexibilität hinsichtlich möglicher Materialien für die nicht aus kristallinem Silizium bestehenden Sub-Zellen ermöglicht. Denkbar wären Sub-Zellen mit Absorbern aus III-V, II-VI und I-III-VI Verbindungshalbleitern, mit Absorbern aus Perovskiten, sowie mit Absorbern aus Germanium oder amorphem Silizium. In allen Fällen kann es vorteilhaft sein, an der Oberfläche des Silizium-Absorbers, die zu einem angrenzenden Absorber hin ausgerichtet ist, einen Ladungsträger-selektiven Kontakt bestehend aus einer aus einem dünnen Grenzflächenoxid (bzw. anderen Grenzflächendielektrikum) und einer darauf abgeschiedenen dotierten, amorphen oder teilkristallinen oder polykristallinen, überwiegend aus Silizium bestehenden Schicht aufzubringen, da dessen elektrische und optische Eigenschaften unabhängig von der Art der angrenzenden Schichten sind.

### KURZE BESCHREIBUNG DER ZEICHNUNGEN

Weitere Merkmale und Vorteile der vorliegenden Erfindung werden einem Fachmann aus der nachfolgenden Beschreibung von beispielhaften Ausführungsformen und unter Bezugnahme auf die begleitenden Zeichnungen ersichtlich, wobei weder die Beschreibung noch die Zeichnungen als die Erfindung einschränkend auszulegen sind.

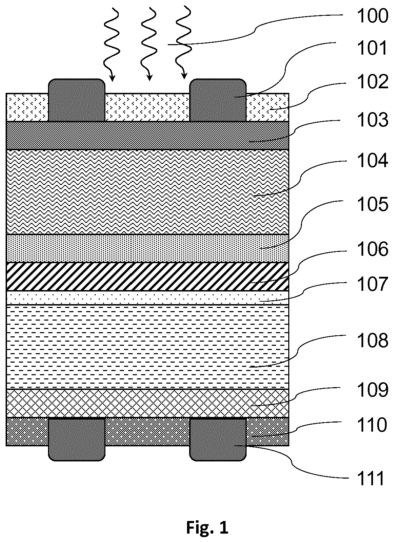

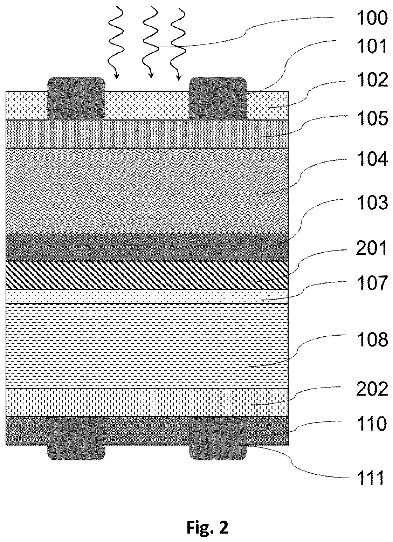

Fig. 1 und Fig. 2 zeigen eine schematische Darstellung von Tandem-Solarzellen gemäß möglichen Ausführungsformen der vorliegenden Erfindung.

Die in den Figuren dargestellten Details sind jeweils nur schematisch veranschaulicht und nicht maßstabsgetreu wiedergegeben. Insbesondere entsprechen die dargestellten Schichtdicken und Proportionen nicht tatsächlichen Verhältnissen, bei denen auf ein Substrat gebrachte Schichten wesentlich dünner sind als in den Figuren dargestellt.

### AUSFÜHRLICHE BESCHREIBUNG DER BEVORZUGTEN AUSFÜHRUNGSFORMEN

Figur 1 zeigt eine schematische Darstellung einer Tandem-Solarzelle gemäß der ersten von zwei bevorzugten Ausführungsformen der vorliegenden Erfindung.

Wie in Figur 1 dargestellt, weist die Tandemsolarzelle zwei verschiedene Absorber 104, 108 aus unterschiedlichen Materialien auf. Alternativ könnten auch drei oder mehr verschiedene Absorber-Materialien verwendet werden. In jedem Fall besteht gemäß der vorliegenden Erfindung ein erster Absorber aus Silizium (108 in Fig. 1).

Der Silizium-Absorber 108 kann beispielsweise ein Wafer aus kristallinem, insbesondere monokristallinem oder multikristallinem Silizium, sein. Gegebenenfalls wurde von den Oberflächen des Silizium-Absorbers 108 ein Sägeschaden entfernt. Der Silizium-Absorber 108 weist typischerweise Dicken im Bereich von 30 bis 500 µm, vorzugsweise 50 bis 300 µm, auf. Laterale Abmessungen liegen typischerweise im Bereich von 0,1 x 0,1 cm² bis 200 x 200 cm². Der Silizium-Absorber 108 kann entweder p dotiert, n dotiert oder undotiert bzw. intrinsisch sein. Der Silizium-Absorber 108 weist dabei vorzugsweise einen einheitlichen Dotierungstyp auf, d.h. ist über seine gesamte Dicke hin p dotiert, über seine gesamte Dicke hin n dotiert oder über seine gesamte Dicke hin undotiert bzw. intrinsisch. Dotierungskonzentrationen können dabei über die Dicke hin variieren. Eine mögliche Oberflächenmorphologie des Silizium-Absorbers 108 ist eine planare Vorder- und Rückseite, wie in Fig. 1 dargestellt. Alternativ kann beispielsweise die Vorderseite und/oder die Rückseite des Silizium-Absorbers 108 texturiert sein.

Der zweite Absorber 104 besteht aus einem von Silizium verschiedenen Material. In der in Figur 1 dargestellten Ausführungsform der vorliegenden Erfindung ist der zweite Absorber 104 aus einem Material, welches Licht mit Photonenenergien oberhalb der Silizium-Bandlücke von 1,12 eV, aber unterhalb einer Energie von beispielsweise 1,2 - 2,2 eV oder 1,2-1,9 eV, bevorzugt von 1,4-1,8 eV, größtenteils zu dem darunter liegenden Silizium-Absorber 108 transmittiert, und Licht mit höheren Photonenenergien effektiv absorbiert und zur Generation von Elektron-Loch-Paaren nutzt. Alternativ könnte der Absorber 108 auch aus einem Material bestehen, welches Licht mit Photonenenergien unterhalb der Silizium-Bandlücke von 1,12 eV absorbiert und zur Generation von Elektron-Loch-Paaren nutzt, wobei sich der zweite Absorber 104 in diesem Fall, anders als in Figur 1 dargestellt, auf der der Beleuchtung 100 abgewandten Seite des Silizium-Absorbers 108 befinden würde.

Mögliche Materialien für den zweiten Absorber 104 laut der in Figur 1 dargestellten Ausführungsform der Erfindung sind Halbleiter mit einer höheren Bandlücke als Silizium, beispielsweise Verbindungshalbleiter aus der III-V , II-VI und I-III-VI Materialklasse, organische Materialien mit einem energetischen Abstand zwischen dem obersten besetzten und dem untersten unbesetzten Energieniveau oberhalb von 1,3 eV, sowie eine Verbindung von organischen und anorganischen Stoffen, beispielswiese aus der Materialklasse der Perovskite. Die Dicke des zweiten Absorbers 104 ist an das jeweilige Material anzupassen, wobei die Diffusionslänge der Minoritäts-Ladungsträger im Absorber 104 eine obere Grenze, die Anforderung an eine effektive Absorption des Lichtes eine untere Grenze bzgl. der Dicke des Absorbers 104 impliziert. Beispielsweise läge für einen zweiten Absorber 104 aus der Materialklasse der III-V-Halbleiter mit direktem Bandgap die Dicke des Absorbers 104 im Bereich von 0,05 - 50 µm, bevorzugt im Bereich 0,5 µm - 5 µm. Die bevorzugte Dicke für einen zweiten Absorber 104 aus der Materialklasse der Perovskite läge in einem Bereich von 0,05 µm - 3 µm. Der zweite Absorber kann dabei einen einheitlichen Dotierungstyp aufweisen, d.h. über seine gesamte Dicke hin p dotiert, über seine gesamte Dicke hin n dotiert oder über seine gesamte Dicke hin undotiert bzw. intrinsisch sein. Dotierungskonzentrationen können dabei über die Dicke hin variieren.

Zentral für die Erfindung ist die an den Silizium-Absorber 108 angrenzende Doppel-Schicht aus beispielsweise einem dünnen Grenzflächenoxid 107 und einer im Fall der in Figur 1 dargestellten Ausführungsform p dotierten, amorphen oder teilkristallinen oder polykristallinen Silizium-Schicht 106. Zusammen bilden die Schichten 107 und 106 einen sogenannten Ladungsträger-selektiven Kontakt. Dieser ist in der Figur 1 dargestellten Ausführungsform transparent für die im Silizium-Absorber 108 generierten Löcher, und leitet diese effizient zu den darüber liegenden Schichten weiter. Die im Silizium-Absorber 108 generierten Elektronen werden in der Figur 1 dargestellten Ausführungsform jedoch nahe bzw. an der Grenzfläche zwischen dem Silizium-Absorber 108 und dem Grenzflächenoxid 107 blockiert, und können dadurch nicht in die darüber liegenden Schichten gelangen. Somit werden Rekombinationsverluste an der mit den Schichten 107, 106 bedeckten Oberfläche des Silizium-Absorbers minimiert, und zwar unabhängig von den Eigenschaften der darüber liegenden Schichten. Der Ladungsträger-selektive Kontakt bestehend aus der Doppelschicht 107, 106 befindet sich auf der dem anderen Absorber 104 zugewandten Seite des Silizium-Absorbers 108. Sollte sich, anders als in Figur 1 dargestellt, der andere Absorber 104 auf der lichtabgewandten Seite des Absorbers 108 befinden oder sollte dort ein dritter Absorber vorhanden sein, würde auch die lichtabgewandte Seite des Silizium-Absorbers 108 von einem solchen Ladungsträger-selektiven Kontakt begrenzt werden.

Das Grenzflächenoxid 107 wird in der Literatur teilweise als Tunneloxid bezeichnet, wobei der Ladungsträgertransport durch dieses Oxid nicht zwangsläufig auf Tunneln basieren muss. Das Grenzflächenoxid 107 kann auf verschiedene Weise auf den Silizium-Absorber 108 aufgebracht werden. Beispielsweise kommen thermische Oxidationen, nasschemische Oxidation, Oxidationen durch Bestrahlung unter Anwesenheit von Ozon, sowie chemische Gasphasen-Abscheideprozesse in Frage. Die bevorzugte Dicke des Grenzflächenoxides 106 liegt im Bereich 0,5-5 nm. Die amorphe oder teilkristalline oder polykristalline Silizium-Schicht 106 kann ebenfalls mittels verschiedenen Verfahren abgeschieden werden. Geeignet hierfür sind unter anderem chemische Gasphasen-Abscheideprozesse, entweder unterstützt durch Plasma-Anregung oder durch thermische Anregung. Aber auch alternative Prozesse, beispielsweise Sputtern oder das Drucken oder Spincoating von siliziumhaltigen Stoffen kommen für die Abscheidung der amorphen oder teilkristallinen oder polykristallinen Silizium-Schicht 106 in Frage. Die in der in Figur 1 dargestellten Ausführungsform notwendige p Dotierung der Schicht 106 kann entweder insitu während der Schichtabscheidung, oder auch nachträglich erfolgen. Für eine nachträgliche Dotierung kommen Prozesse wie beispielsweise thermische Diffusion aus der Gasphase, Ionenimplantation mit anschließender Ausheilung oder das Aufbringen von Dotierstoffen mittels Druckverfahren oder SpinCoating und anschließendes thermisches Eintreiben in Frage. Die Dotierstoffkonzentration in der amorphen oder teilkristallinen oder polykristallinen Silizium-Schicht 106 soll vorzugsweise mehr als 10¹⁸cm⁻³ betragen, um die Ausbildung eines Tunnelkontaktes zur darüber liegenden Schicht 105 zu ermöglichen. Die darüber liegende Schicht 105 dient in diesem Fall zur Extraktion von Elektronen aus dem ersten Absorber 104 und ist in Regelfall entgegengesetzt dotiert zu der amorphen oder teilkristallinen oder polykristallinen Silizium-Schicht 106. Um ein Tunneln zu ermöglichen, kann diese darüber liegende Schicht 105 ähnlich stark dotiert sein wie die amorphe oder teilkristalline oder polykristalline Silizium-Schicht 106, d.h. eine Dotierungskonzentration kann vorzugsweise mehr als 10¹⁸cm⁻³ betragen. Die Dicke der amorphen oder teilkristallinen oder polykristallinen Silizium-Schicht 106 liegt typischerweise im Bereich 5 - 1000 nm, bevorzugt im Bereich 10 - 300 nm. Sie kann gezielt variiert werden, um durch eine Variation der Interferenzen und/oder der Absorption in Schicht 106 die im Silizium-Absorber 108 generierte Stromdichte an die im Absorber 104 generierte Stromdichte anzupassen. Ob die Silizium-Schicht 106 amorph, teilkristallin oder polykristallin ist, hängt von den Abscheidebedingungen und/oder der thermischen Nachbehandlung dieser Schicht ab, wobei die Mikrostruktur der Schicht 106 im Allgemeinen für die vorliegende Erfindung irrelevant ist.

Neben diesen ausführlich beschriebenen Bestandteilen kann die Tandemsolarzelle laut Figur 1 weitere Strukturen aufweisen, deren genaue Ausführung für die vorliegende Erfindung nicht maßgeblich ist. Das sind entsprechend Figur 1:
- Eine Schicht 103 zur Extraktion von Löchern aus dem Absorber 104, sowie eine Schicht 105 zur Extraktion von Elektronen aus dem Absorber 104. Die können beispielsweise geeignet dotierte Halbleiterschichten sein, insbesondere wenn der Absorber 104 selbst aus einem Halbleitermaterial besteht, oder auch Materialien, die zu dem Absorber 104 einen Heteroübergang mit geeigneter elektronischer Struktur bzw. mit geeignetem Bandalignement bilden. In der in Figur 1 dargestellten Ausführungsform der Erfindung grenzt die Schicht 105 zur Extraktion von Elektronen aus dem Absorber 104 an den für Löcher aus dem Silizium-Absorber 108 transparenten Ladungsträger-selektiven Kontakt 107, 106. Zwischen der p-dotierten amorphen oder teilkristallinen oder polykristallinen Silizium-Schicht 106 und der Schicht 105 zur Extraktion von Elektronen aus dem Absorber 104 bildet sich gegebenenfalls ein Tunnelkontakt aus. Die Schicht 105 kann dabei selbst eine hohe Selektivität aufweisen, d.h. sie kann transparent bzw. durchlässig für die im Absorber 104 generierten Elektronen sein, die im Absorber 104 generierten Löcher jedoch blockieren und somit Rekombination an der mit der Schicht 105 bedeckten Seite des Absorbers 104 minimieren.
   Sowohl die Schicht 105, als auch die Schicht 103 sollten möglichst transparent für Licht über einen weiten Bereich des Sonnenspektrums sein.
- Eine Schicht 109 zur Extraktion von Elektronen aus dem Silizium-Absorber 108. Diese kann beispielsweise aus n dotiertem kristallinem Silizium bestehen, und entweder, wie in Figur 1 dargestellt, die gesamte Rückseite des Silizium-Absorbers 108 bedecken, oder nur auf die Bereiche der Rückseitenkontakte 111 beschränkt sein. Alternativ kann die Schicht 109 auch aus mehreren Unterschichten bestehen, z.B. aus einem Grenzflächenoxid sowie einer n dotierten amorphen oder teilkristallinen oder polykristallinen Silizium-Schicht. Weitere Realisierungsmöglichkeiten der Schicht 109 sind von kristallinem Silizium verschiedene Halbleitermaterialien, die zu dem Silizium-Absorber 108 einen Heteroübergang mit geeigneter Bandstruktur bilden. Ebenso möglich sind organische Schichten mit geeigneten elektronischen Eigenschaften.
- Eine Schicht 102 zur Verringerung der Reflektion an der Vorderseite der Solarzelle und /oder zu deren Passivierung. Diese sollte möglichst transparent für Licht über den Bereich des gesamten Sonnenspektrums sein.
- Eine Schicht 110 zur Erhöhung der internen Reflektion an der Rückseite der Solarzelle und /oder zu deren Passivierung. Dies kann beispielsweise eine dielektrische Schicht oder ein Schichtstapel aus dielektrischen Schichten, beispielsweise Siliziumoxid, Siliziumnitrid oder Aluminiumoxid sein. Auch eine Strukturierung der Rückseite des Silizium-Absorbers zur Erhöhung der internen Reflektion ist denkbar.
- Eine Vorderseitenmetallisierung 101 sowie eine Rückseitenmetallisierung 111. Während die Vorderseitenmetallisierung 101, sollte sie nicht aus einem transparenten Material bestehen, nicht ganzflächig aufgebracht werden kann, ist, anderes als in Figur 1 dargestellt, eine ganzflächige Rückseitenmetallisierung durchaus möglich. Mögliche Materialien sind gut leitfähige Metalle wie Kupfer, Silber, Gold, Platin, Nickel, Titan, Palladium und Aluminium, gegebenenfalls in Verbindung mit weiteren Bestandteilen zur Verbesserung des Kontaktes zu den Schichten 103 und 110.

Es ist denkbar, dass spezielle Ausgestaltungen dieser Strukturen mehrere Funktionen gleichzeitig übernehmen, so dass einzelne Strukturen überflüssig werden. Beispielsweise kann die Schicht 103 zur Extraktion von Löchern aus dem Absorber 104 gleichzeitig die Reflektion der Vorderseite der Solarzelle verringern, so dass die Schicht 102 überflüssig ist.

Die möglichen Herstellungsverfahren für die Schichten 102, 103, 104, 105 sind stark abhängig von den verwendeten Materialien. Besteht eine dieser Schichten aus einem Halbleitermaterial, kann diese beispielsweise mittels Sputtern, mittels Verdampfen, mittels Molekularstrahlepitaxie, mittels chemischer Gasphasenabscheidung oder mit Hilfe eines anderen Verfahrens direkt auf die darunterliegenden Schichten abgeschieden werden. Alternativ könnte der Absorber 104, eventuell zusammen einer oder mehreren der Schichten 105, 103, 102, 101, separat hergestellt werden und später mit den darunterliegenden Schichten mechanisch, elektrisch und optisch verbunden werden. Hierfür kommen Verfahren wie Bonding, aber auch das Kleben mittels eines leitfähigen, transparenten Klebers in Frage. Besteht eine der Schichten aus einem organischen Material oder aus einem Material aus der Klasse der Perovskite, kommen zusätzlich Abscheideverfahren wie Spincoating und verschiedene Druckverfahren in Frage. In der Regel sind diese Herstellungsverfahren mit einem bestimmten Temperaturbudget verbunden, beispielsweise mit Prozesstemperaturen über 200°C. Der Umstand, dass die elektrischen Eigenschaften des Ladungsträger-selektiven Kontaktes bestehend aus dem dünnen Grenzflächenoxid 107 und der p dotierten, amorphen oder teilkristallinen oder polykristallinen Silizium-Schicht 106 auch bei Prozesstemperaturen von bis zu 1100°C nicht zwangsläufig degradieren, ermöglicht die Anwendbarkeit von temperaturbehafteten Herstellungsverfahren für die Schichten 105, 104, 103, 102.

Figur 2 zeigt eine schematische Darstellung einer Tandem-Solarzelle gemäß der zweiten von zwei bevorzugten Ausführungsformen der vorliegenden Erfindung.

Der wesentliche Unterschied zu der in Figur 1 dargestellten Ausführungsform ist, dass die amorphe oder teilkristalline oder polykristalline Silizium-Schicht 201 nicht wie die Schicht 106 p dotiert, sondern n dotiert ist. Dadurch wird der aus dem Grenzflächenoxid 107 und der n-dotierten amorphen oder teilkristallinen oder polykristallinen Silizium-Schicht 201 bestehende Ladungsträger-selektive Kontakt transparent bzw. durchlässig für die im Silizium-Absorber 108 generierten Elektronen, und leitet diese effizient zu den darüber liegenden Schichten weiter. Die im Silizium-Absorber 108 generierten Löcher werden in der in Figur 2 dargestellten Ausführungsform jedoch nahe bzw. an der Grenzfläche zwischen dem Silizium-Absorber 108 und dem Grenzflächenoxid 107 blockiert, und können dadurch nicht in die darüber liegenden Schichten gelangen. Somit werden Rekombinationsverluste an der mit den Schichten 107, 201 bedeckten Oberfläche des Silizium-Absorbers minimiert, und zwar unabhängig von den Eigenschaften der darüber liegenden Schichten. Bezüglich Schichtdicken, Dotierung und Herstellungsverfahren ist die n-dotierte amorphe oder teilkristalline oder polykristalline Silizium-Schicht 201 identisch mit der p-dotierten amorphen oder teilkristallinen oder polykristallinen Silizium-Schicht 106, so dass an dieser Stelle an die oben ausgeführte ausführliche Beschreibung verwiesen wird.

An der lichtabgewandten Seite des Silizium-Absorbers 108 ist entsprechend der in Figur 2 dargestellten Ausführung der Erfindung die Extraktion von im Absorber 108 generierten Löchern notwendig. Diese Aufgabe übernimmt die Schicht 202. Diese kann beispielsweise aus p dotierten kristallinem Silizium bestehen, und entweder, wie in Figur 2 dargestellt, die gesamte Rückseite des Silizium-Absorbers 108 bedecken, oder nur auf die Bereiche der Rückseitenkontakte 111 beschränkt sein. Alternativ kann die Schicht 202 auch aus mehreren Unterschichten bestehen, z.B. aus einem Grenzflächenoxid sowie einer p dotierten amorphen oder teilkristallinen oder polykristallinen Silizium-Schicht. Weitere Realisierungsmöglichkeiten der Schicht 201 sind von kristallinem Silizium verschiedene Halbleitermaterialien, die zu dem Silizium-Absorber 108 einen Heteroübergang mit geeigneter Bandstruktur bilden. Ebenso möglich sind organische Schichten mit geeigneten elektronischen Eigenschaften.

Desweitern sind die Positionen der Schicht 103 zur Extraktion von Löchern aus dem Absorber 104 und der Schicht 105 zur Extraktion von Elektronen aus dem Absorber 104 in Figur 2 gegenüber Figur 1 vertauscht. Die Schicht 103 zur Extraktion von Löchern aus dem Absorber 104 befindet sich nun auf der lichtabgewandten Seite des Absorbers 104 und grenzt somit direkt an die n dotierte amorphe oder teilkristalline oder polykristalline Silizium-Schicht 201. Zwischen den Schichten 201 und 103 kann sich entsprechend der Figur 2 dargestellten Ausführungsform der Erfindung ein Tunnelkontakt ausbilden. Die verschiedenen Realisierungsmöglichkeiten der Schichten 103, 105 sind identisch zu der oben gegebenen Beschreibung beider Schichten.

Zusammenfassend wird gemäß einer Ausführungsform eine Tandem-Solarzellenstruktur beschrieben, aufweisend folgende Merkmale:
(a) Monolithischer Aufbau mit mindestens zwei verschiedenen Absorber-Materialien (104 und 108) zur photovoltaischen Energieumwandlung
(b) Ein Absorber 108 bestehend aus kristallinem Silizium
(c) Einen sich auf der zum angrenzenden Absorbers 104 gerichteten Seite des Silizium-Absorbers 108 befindlichen Ladungsträger-selektiven Kontakt
(d) Aufbau des Ladungsträger-selektiven Kontaktes aus einem dünnen Grenzflächenoxid 107 und einer darauf aufgebrachten amorphen, teilkristallinen oder polykristallinen, hauptsächlich aus Silizium bestehenden, entweder p (106) oder n dotierten (201) Schicht.

Der aus den Schichten 107 und 106 bzw. 201 aufgebaute Ladungsträger-selektive Kontakt gewährleistet eine exzellente Oberflächenpassivierung des kristallinen Silizium-Absorbers 108, sowie die selektive Extraktion eines Ladungsträgertyps aus letzterem über die gesamte Fläche. Somit wird ein vertikaler Stromfluss erreicht, so dass laterale Querleitfähigkeit nicht in jeder Sub-Zelle erforderlich ist. Durch hohe Dotierung der Schicht 106 bzw. 201 kann die Ausbildung eines Tunnelkontaktes zur angrenzenden Schicht erreicht werden. Die Dicke und / oder die Dotierung der Schicht 106 bzw. 201 kann zur Angleichung der Generationsströme in den einzelnen Sub-Zellen genutzt werden. Die Temperaturstabilität der Schichten 107, 106 bzw. 201 ermöglicht die Anwendung von nachfolgenden Herstellungsschritten mit Temperaturen > 400 °C.

### BEZUGSZEICHENLISTE

- 100:: Sonnenlicht
- 101:: Vorderseitenmetallisierung
- 102:: Vorderseitenpassivierung und Anti-Reflektionsschicht
- 103:: Schicht zur Extraktion von Löchern aus erstem Absorber
- 104:: erster Absorber aus einem von kristallinem Silizium verschiedenen Material
- 105:: Schicht zur Extraktion von Elektronen aus erstem Absorber
- 106:: Schicht aus p dotiertem, amorphem oder teilkristallinem oder polykristallinem Silizium
- 107:: Grenzflächenoxid
- 108:: zweiter Absorber aus kristallinen Silizium
- 109:: Schicht zur Extraktion von Elektronen aus zweitem Absorber
- 110:: Rückseitenpassivierung und Rückseitenspiegel
- 111:: Rückseitenmetallisierung
- 201:: Schicht aus n dotiertem, amorphem oder teilkristallinem oder polykristallinem Silizium
- 202:: Schicht zur Extraktion von Löchern aus zweitem Absorber

## Patentansprüche

1. Solarzelle mit mindestens zwei verschiedenen Absorbern (104, 108) aus unterschiedlichen Materialien zur Umwandlung von Strahlungsenergie in elektrische Energie mit Absorption in jeweils unterschiedlichen Spektralbereichen, wobei:
(a) die Solarzelle monolithisch aufgebaut ist,
(b) ein erster Absorber (108) aus kristallinem Silizium besteht, und
(c) sich auf einer zu einem angrenzenden zweiten Absorber (104) gerichteten Seite des ersten Absorbers (108) ein Ladungsträger-selektiver Kontakt befindet, der für einen Ladungsträger-Typ, ausgewählt aus einer Gruppe umfassend Löcher und Elektronen, durchlässiger ist als für den jeweils anderen Ladungsträger-Typ, und der die entsprechende Oberfläche des ersten Absorbers (108) gut passiviert, **dadurch gekennzeichnet, dass**
(d) der Ladungsträger-selektive Kontakt aus einer Schicht aus einem dünnen Grenzflächendielektrikum (107) und einer darauf aufgebrachten amorphen, teilkristallinen oder polykristallinen, hauptsächlich aus Silizium bestehenden, entweder p dotierten (106) oder n dotierten (201) Schicht aufgebaut ist.

2. Solarzelle nach Anspruch 1, wobei die amorphe, teilkristalline oder polykristalline Silizium-Schicht (106, 201) derart hoch dotiert ist, dass ein Tunnelkontakt zu einer darauf aufgebrachten Schicht (105, 103) ermöglicht wird.

3. Solarzelle nach Anspruch 1 oder 2, wobei Interferenzeffekte und/oder Lichtabsorption in der amorphen, teilkristallinen oder polykristallinen Silizium-Schicht (106, 201) über Anpassung einer Schichtdicke und/oder einer Dotierung gezielt eingestellt werden, um eine in dem ersten Absorber (108) generierte Stromdichte an eine in dem zweiten Absorber (104) generierte Stromdichte anzugleichen.

4. Solarzelle nach einem der vorangehenden Ansprüche, wobei das Grenzflächendielektrikum ein Grenzflächenoxid ist.

5. Solarzelle nach einem der vorangehenden Ansprüche, wobei ein auf der der Sonneneinstrahlung (100) zugewandten oder/und abgewandten Seite befindlicher zweiter Absorber (104) aus einem Perovskit-Material besteht.

6. Solarzelle nach einem der vorangehenden Ansprüche, wobei ein auf der der Sonneneinstrahlung (100) zugewandten oder/und abgewandten Seite befindlicher zweiter Absorber (104) aus einem III-V Verbindungshalbleiter besteht.

7. Solarzelle nach einem der vorangehenden Ansprüche, wobei ein auf der der Sonneneinstrahlung (100) zugewandten oder/und abgewandten Seite befindlicher zweiter Absorber (104) aus einem I-III-VI Verbindungshalbleiter besteht.

8. Solarzelle nach einem der vorangehenden Ansprüche, wobei ein auf der der Sonneneinstrahlung (100) zugewandten oder/und abgewandten Seite befindlicher zweiter Absorber (104) aus einem II-VI Verbindungshalbleiter besteht.

9. Solarzelle nach einem der vorangehenden Ansprüche, wobei ein auf der der Sonneneinstrahlung (100) abgewandten Seite befindlicher zweiter Absorber (104) aus Germanium bzw. einem Silizium-Germanium-Gemisch besteht.

10. Solarzelle nach einem der vorangehenden Ansprüche, wobei ein auf der der Sonneneinstrahlung (100) zugewandten Seite befindlicher zweiter Absorber (104) aus amorphem Silizium besteht.

11. Solarzelle nach einem der vorangehenden Ansprüche, wobei das Grenzflächendielektrikum ein beliebiges Grenzflächendielektrikum ausgenommen ein Grenzflächenoxid ist.

## Claims

1. Solar cell comprising at least two different absorbers (104, 108) of different materials for converting radiation energy into electrical energy by absorption in different spectral ranges in each case,
(a) the solar cell being monolithic in construction,
(b) a first absorber (108) consisting of crystalline silicon, and
(c) a charge-carrier-selective contact being located on a face of the first absorber (108) directed towards an adjacent second absorber (104), and being more permeable to one charge carrier type, selected from a group comprising holes and electrons, than to the other charge carrier type, and passivating the corresponding surface of the first absorber (108) well,
**characterised in that**
(d) the charge-carrier-selective contact being constructed from a layer of a thin interface dielectric (107) and an amorphous, semi-crystalline or polycrystalline layer applied thereto, which consists primarily of silicon and is either p-doped (106) or n-doped (201).

2. Solar cell according to claim 1, wherein the amorphous, semi-crystalline or polycrystalline silicon layer (106, 201) is sufficiently highly doped that tunnel contact with a layer (105, 103) applied thereto is made possible.

3. Solar cell according to either claim 1 or claim 2, wherein interference effects and/or light absorption in the amorphous, semi-crystalline or polycrystalline silicon layer (106, 201) are adjusted by adapting a layer thickness and/or doping so as to equalise a current density generated in the first absorber (108) to a current density generated in the second absorber (104).

4. Solar cell according to any of the preceding claims, wherein the interface dielectric is an interface oxide.

5. Solar cell according to any of the preceding claims, wherein a second absorber (104), located on the side facing towards and/or away from the solar radiation (100), consists of a perovskite material.

6. Solar cell according to any of the preceding claims, wherein a second absorber (104), located on the side facing towards and/or away from the solar radiation (100), consists of a III-V compound semiconductor.

7. Solar cell according to any of the preceding claims, wherein a second absorber (104), located on the side facing towards and/or away from the solar radiation (100), consists of a I-III-VI compound semiconductor.

8. Solar cell according to any of the preceding claims, wherein a second absorber (104), located on the side facing towards and/or away from the solar radiation (100), consists of a II-VI compound semiconductor.

9. Solar cell according to any of the preceding claims, wherein a second absorber (104), located on the side facing away from the solar radiation (100), consists of germanium or a silicon-germanium mixture.

10. Solar cell according to any of the preceding claims, wherein a second absorber (104), located on the side facing towards the solar radiation (100), consists of amorphous silicon.

11. Solar cell according to any of the preceding claims, wherein the interface dielectric is any desired interface dielectric excluding an interface oxide.

## Revendications

1. Cellule solaire comportant au moins deux absorbeurs différents (104, 108) composés de matériaux divers destinée à la conversion d'énergie de rayonnement en énergie électrique avec une absorption dans respectivement diverses plages du spectre, dans laquelle :
(a) la cellule solaire est structurée de manière monolithique,
(b) un premier absorbeur (108) est constitué de silicium cristallin, et
(c) un contact sélectif porteur de charge se trouve sur une face du premier absorbeur (108) dirigée vers un deuxième absorbeur (104) contigu ; ledit contact sélectif étant plus perméable pour un type de porteur de charge, qui est choisi dans le groupe constitué par des trous et des électrons, que pour respectivement l'autre type de porteur de charge, et assurant une bonne passivation de la surface correspondante du premier absorbeur (108),
**caractérisée en ce que**
(d) le contact sélectif porteur de charge est structuré à partir d'une couche composée d'un diélectrique de surfaces limites (107) de faible épaisseur et d'une couche amorphe, en partie cristalline ou polycristalline, appliquée sur laquelle, principalement composée de silicium soit à dopage p (106), soit à dopage n (201).

2. Cellule solaire selon la revendication 1, dans laquelle la couche (106, 201) de silicium amorphe, en partie cristalline ou polycristalline présente un fort dopage, de telle sorte qu'un contact en tunnel avec une couche (105, 103) appliquée sur la couche (106, 201) est rendu possible.

3. Cellule solaire selon la revendication 1 ou 2, dans laquelle des effets d'interférence et/ou une absorption de la lumière sont ajustés de manière ciblée dans la couche (106, 201) de silicium amorphe, en partie cristalline ou polycristalline en ajustant une épaisseur de couche et/ou un dopage, afin d'adapter une densité de courant générée dans le premier absorbeur (108) à une densité de courant générée dans le deuxième absorbeur (104).

4. Cellule solaire selon l'une des revendications précédentes, dans laquelle le diélectrique de surfaces limites est un oxyde de surfaces limites.

5. Cellule solaire selon l'une des revendications précédentes, dans laquelle un deuxième absorbeur (104) qui se trouve sur la face orientée vers le rayonnement solaire (100) et/ou opposée au rayonnement solaire (100), est composé d'un matériau de type pérovskite.

6. Cellule solaire selon l'une des revendications précédentes, dans laquelle un deuxième absorbeur (104) qui se trouve sur la face orientée vers le rayonnement solaire (100) et/ou opposée au rayonnement solaire (100), est composé d'un semiconducteur composite de type III-V.

7. Cellule solaire selon l'une des revendications précédentes, dans laquelle un deuxième absorbeur (104) qui se trouve sur la face orientée vers le rayonnement solaire (100) et/ou opposée au rayonnement solaire (100), est composé d'un semiconducteur composite de type I-III-VI.

8. Cellule solaire selon l'une des revendications précédentes, dans laquelle un deuxième absorbeur (104) qui se trouve sur la face orientée vers le rayonnement solaire (100) et/ou opposée au rayonnement solaire (100), est composé d'un semiconducteur composite de type II-VI.

9. Cellule solaire selon l'une des revendications précédentes, dans laquelle un deuxième absorbeur (104) qui se trouve sur la face opposée au rayonnement solaire (100), est composé de germanium, respectivement d'un mélange de silicium et de germanium.

10. Cellule solaire selon l'une des revendications précédentes, dans laquelle un deuxième absorbeur (104) qui se trouve sur la face orientée vers le rayonnement solaire (100) est composé de silicium amorphe.

11. Cellule solaire selon l'une des revendications précédentes, dans laquelle le diélectrique de surfaces limites est un diélectrique de surfaces limites quelconque à l'exception d'un oxyde de surfaces limites.
